# EUROPEAN PATENT SPECIFICATION

(11) **EP 2 352 163 B1**
(45) Date of publication and mention of the grant of the patent: **19.07.2017**
(21) Application number: 11151535.9
(22) Date of filing: 20.01.2011
(51) Int. Cl.: H01L 21/67, B28D 5/00, B28D 5/04, H01L 31/18

(54) **Scribing apparatus for thin film solar cells**
Beschriftungsvorrichtung für Dünnfilm-Solarzellen
Appareil de gravure pour cellules solaires à couche mince

(30) Priority: 27.01.2010 JP 2010015958
(43) Date of publication of application: 03.08.2011
(73) Proprietor: Mitsuboshi Diamond Industrial Co., Ltd., Suita-city, Osaka 564-0044 (JP)
(72) Inventor: Soyama, Masanobu, Suita-city Osaka 564-0044 (JP)
(74) Representative: TBK

(56) References cited:
- EP-A1- 2 213 632
- WO-A1-2008/126502
- WO-A1-2009/022586
- JP-A- 9 295 822
- JP-A- 2000 315 809
- JP-A- 2002 033 498
- JP-A- 2002 080 234
- JP-A- 2009 196 211
- US-A- 3 680 213
- US-A1- 2003 084 578
- US-B1- 7 165 331

## Description

### [Technical Field]

The present invention relates to a scribing apparatus for thin film solar cells according to the preamble of claim 1.

### [Background Art]

Thin film solar cells generally have an integrated structure where a number of unit cells are connected in series on a substrate.

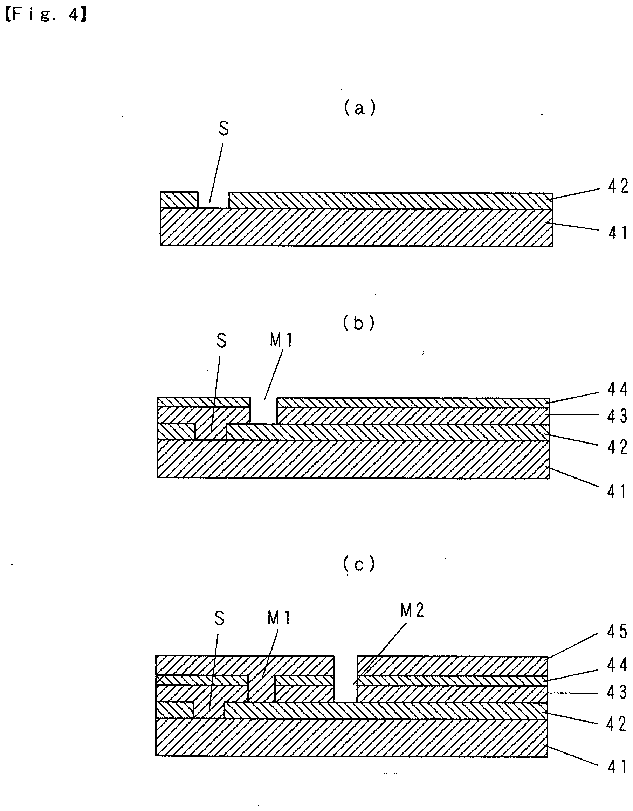

A conventional manufacturing method for chalcopyrite compound based integrated thin film solar cells is described below. Figs 4(a) to 4(c) are schematic diagrams showing the steps for manufacturing a CIGS thin film solar cell. First, as shown in Fig 4(a), an Mo electrode layer 42 which becomes positive lower electrodes is formed on an insulating substrate 41 made of soda lime glass (SLG) in accordance with a sputtering method, and after that a trench S for separating lower electrodes is created in the thin film solar cell substrate in a scribing process, before a light absorbing layer is formed.

After that, as shown in Fig 4(b), a light absorbing layer 43 made of a compound semiconductor (CIGS) thin film is formed on the Mo electrode layer 42 in accordance with a vapor deposition method or sputtering method, and an insulating layer 44 is formed of a ZnO thin film on top. Then, a trench M1 for contact between electrodes that extends to the Mo electrode layer 42 is created in the thin film solar cell substrate in a location at a predetermined distance from the trench S for separating lower electrodes, to the side, in accordance with a scribing process before a transparent electrode layer is formed.

Next, as shown in Fig 4(c), a transparent electrode layer 45 is formed of a ZnO:Al thin film on top of the insulating layer 44 as upper electrodes, so that a solar cell substrate having the functional layers required for power generation using photoelectric conversion can be provided, and a trench M2 for separating electrodes which extends to the Mo electrode layer 42 below is created in accordance with a scribing process.

During the above process for manufacturing integrated thin film solar cells a mechanical scribing method according to which a thin film is partially removed using a tool, such as a cutter knife or a needle, is used as a technology for creating trenches M1 and M2 through scribing. However, the width of the trenches after removing the thin film is not consistent, and a problem arises, such that too much may be removed.

Therefore, a mechanical scribing method according to which a thin film can be processed with a stable trench width has been proposed (see JP 2002-033498 A). In this document, a trench creating tool and a peeling tool having a process load adjusting mechanism with a plate spring and a load meter for adjusting the processing load are used. Thus, two trenches in V shape are initially created using the trench creating tool while adjusting the processing load using the processing load adjusting mechanism, and subsequently the thin film between the two trenches is removed using the peeling tool. Another method, according to which the processing load is adjusted using air pressure is also disclosed.

In the case where trenches M1 and M2 for electrodes are created in integrated thin film solar cells in accordance with a mechanical scribing method, it is required to adjust the load applied to the blade of the tool so that it is constant during scribing. When the load applied to the blade is greater than the set value, the blade bites in too much and shaves too much, and at the same time, too great a load applied to the blade causes the thin film to peel irregularly or too much, and thus the properties of the solar cells deteriorate, and the yield lowers. Conversely, in the case where the pressure is too small, the created trenches may not have the necessary depth. While trenches are created in integrated thin film solar cells, however, it is not sufficient simply to make the blade pressure constant, and it is required for the load to be controlled with high precision when the load is low. In the above described chalcopyrite compound based thin film solar cells, for example, the light absorbing layer 43 made of a compound semiconductor (CIGS) thin film on the Mo electrode layer 42, the insulating layer 44 made of a ZnO thin film and the transparent electrode layer 45 made of an A1 thin film are as thin as 0.05 µm to 1 µm. Therefore, a scribe head that can be controlled with a load of as low as approximately 0.1 N to 0.5 N (Newton) is required.

However, even in the case where the processing load is controlled using the peeling tool having a processing load adjusting mechanism in JP 2002-033498 A, a problem may arise, such that too much is shaved off, unless the load applied to the blade can be controlled in a low range of approximately 0.1 N to 0.5 N.

That is to say, fine adjustment with a low load is very difficult in accordance with a pressure applying method using a conventional board spring or load meter and a pressure load method using an air pressure cylinder, and therefore, when trenches are created in thin film solar cells with the tool, the products are greatly inconsistent and the yield poor, the reproducibility is poor, and there is a problem with the durability.

WO 2008/126502 A1 shows a generic scribing apparatus for thin film solar cells according to the preamble of claim 1, with which the blade of a trench creating tool that is attached to the scribe head is pressed against the surface of a solar cell substrate along a line along which the solar cell substrate is to be scribed when the trench creating tool is moved over the solar cell substrate, so that a trench is created in the thin film formed on the surface of the solar cell substrate, comprising: a tool holder that is attached to the scribe head in such a manner as to be movable upward and downward and holds the trench creating tool; an air cylinder for pressuring the tool holder against the surface of the solar cell substrate; and a spring for pressuring the tool holder upward.

Further scribing apparatuses according to the prior art are shown in JP 2002 080234 A, JP 2009 196211 A, US 7 165 331 B1 and EP 2 213 632 A1 representing a prior art document according to Art. 54(3) EPC.

### Summary of the Invention

It is therefore an object of the present invention to further develop a scribing apparatus for thin film solar cells according to the preamble of claim 1 such that the load to be applied with the scribing apparatus can be kept constant and fine adjustment with a low load is possible.

The object of the present invention is achieved by a scribing apparatus for thin film solar cells having the features of claim 1.

A further advantageous development of the present invention is defined in the dependent claim.

According to an advantage of the present invention, thin films on the solar cell substrate can be shaved with precision, the thin films can be prevented from peeling irregularly, and straight and precise scribe lines can be created at low cost.

According to the present invention, the weight of the tool holder, including the trench creating tool, is supported by a spring for compensation, so that no load is applied, and therefore the response to change in the pressure is excellent. In addition, an air cylinder that is controlled by an electrical air regulator is used as a pressure applying means, and therefore the system can be controlled stably and at high speed with a low load, and as a result thin films on the solar cell substrate can be shaved with precision, the thin films can be prevented from peeling irregularly, and straight and precise trenches can be created. Furthermore, the combination of the spring and the air cylinder that is controlled by an electrical air regulator can provide a lightweight and simple scribe head at low cost.

The tensile force of the spring may be set so that the weight of the tool holder, including the trench creating tool, provides no load in the structure in a position where the blade of the trench creating tool makes contact with the surface of the solar cell substrate. As a result, the fluctuation in the load applied during processing is conveyed directly to the air cylinder, so that the pressure can be controlled at high speed and with high precision and a low load via an electrical air regulator.

### [Brief Description of the Drawings]

Fig 1 is a perspective diagram showing a scribing apparatus for integrated thin film solar cells using a scribe head according to one embodiment of the present invention;
Fig 2 is a perspective diagram showing a scribe head;
Fig 3 is a diagram illustrating an air cylinder in the scribe head and an electrical air regulator for controlling it; and
Figs 4(a) to 4(c) are schematic diagrams showing the steps for manufacturing conventional CIGS based thin film solar cells.

### [Best Mode for Carrying Out the Invention]

In the following, the embodiments of the present invention are described in detail in reference to the drawings. First the structure of the scribing apparatus of the present invention as a whole is described.

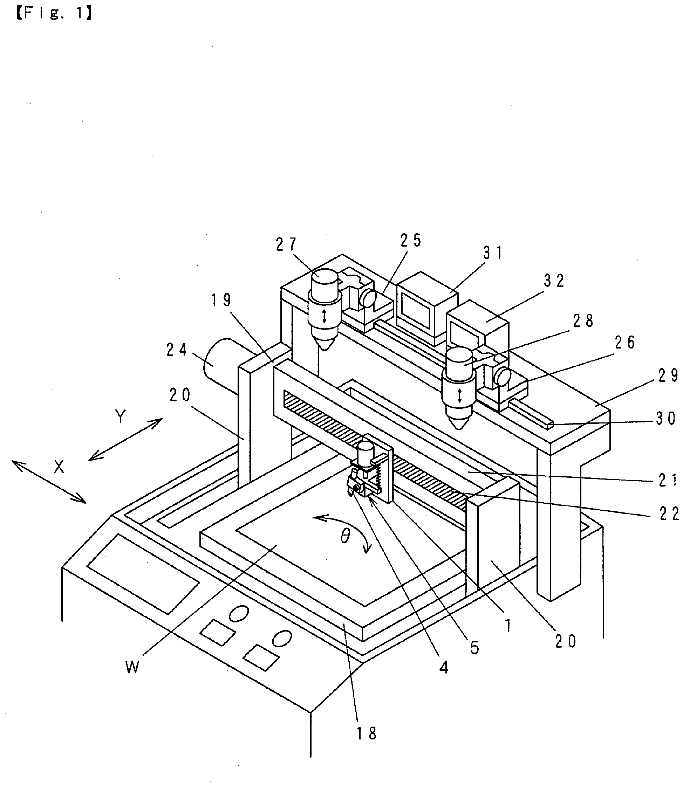

Fig 1 is a perspective diagram showing the scribing apparatus for integrated thin film solar cells according to one embodiment. The scribing apparatus has a table 18 which is movable in an approximately horizontal direction (direction Y) and rotatable 90 degrees or an angle θ in the horizontal plane, where the table 18 essentially forms a means for holding a solar cell substrate W.

A bridge 19 formed of supports 20, 20 on either side of the table 18 and a guide bar 21 that runs in the direction X is provided over the table 18. A scribe head 1 is provided so as to be movable along a guide 22 that is formed on the guide bar 21, and moves in the direction X as the motor 24 rotates. A tool holder 5 for holding a trench creating tool 4 for scribing the surface of a thin film on the solar cell substrate W mounted on the table 18 is provided on the scribe head 1.

In addition, cameras 27 and 28 are provided on bases 25 and 26 which are movable in the directions X and Y, respectively. The bases 25 and 26 move along the guide 30, which runs over the support 29 in the direction X. The cameras 27 and 28 can be moved upward and downward through manual operation so as to adjust the focal point. Images taken by the cameras 27 and 28 are displayed on monitors 31 and 32.

In each step, the scribe line created in the previous step can be observed on the surface of the solar cell substrate W mounted on the table 18. Therefore, in order to scribe the solar cell substrate W in each step, the scribe line created in the previous step is used as a mark for specifying the scribe point. For example, in the case where a trench for making contact between upper and lower electrodes is created in the solar cell substrate W where a light absorbing layer 43 and an insulating layer 44 are formed on top of the scribed lower electrode layer (Mo electrode layer) 42, the scribe line created in the lower electrode layer 42 is used as a mark for specifying the location in which a trench is to be formed. That is to say, the scribe line created in the lower electrode layer 42 is captured by the cameras 27 and 28, and thus the position of the solar cell substrate W can be adjusted. Concretely, the scribe line created in the lower electrode layer 42 that can be observed from above the surface of the solar cell substrate W supported on the table 18 is captured by the cameras 27 and 28, so that the position of the scribe line created in the lower electrode layer 42 can be specified. On the basis of the specified location of the scribe line created in the lower electrode layer, the location in which a trench for contact between upper and lower electrodes is to be created (scribe point) is found, and the location of the solar cell substrate W is adjusted so as to adjust the scribe point.

In addition, whenever the table 18 is moved in the direction Y with a predetermined pitch, the blade of the trench creating tool 4 attached to the scribe head 1 is moved in the direction X in such a state that the blade is pressed against the surface of the solar substrate W with a pressure of a set value by means of the below described air cylinder 6 having a small diameter, and thus the surface of the solar cell substrate W is scribed in the direction X. In the case where the surface of the solar cell substrate W is scribed in the direction Y, the table 18 is rotated 90 degrees and the same operation is repeated.

Next, the scribe head 1 of the present invention is described.

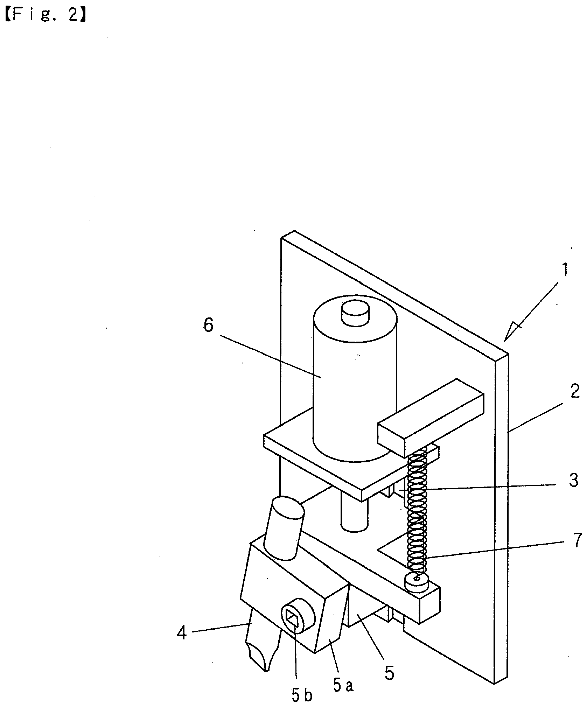

As shown in detail in Fig 2, the scribe head 1 has a plate-like base 2, a tool holder 5 that is attached to the base 2 in such a manner as to be slidable upward and downward over a rail 3, and holds a trench creating tool 4, and an air cylinder 6 having a small diameter that is held on the base 2 above the above described tool holder 5 in order to apply pressure to the trench creating tool 4. The tool holder 5 has a tool attachment 5a that is rotatable around an attachment bolt 5b. The trench creating tool 4 is attached to this attachment 5a in such a manner that the angle at which the trench creating tool 4 is adjustable, and thus the angle between the blade of the trench creating tool 4 and the solar cell substrate W can be adjusted. In addition, it is preferable for the diameter of the above described air cylinder 6 to be approximately 5 mm, but air cylinders having a diameter in a range of 2 mm to 8 mm can also be used.

Furthermore, a spring 7 is provided between the tool holder 5 and the top of the base 2, so that the weight of the tool holder 5, including the above described trench creating tool 4, is negated, and no load is applied. In this case, the tensile force of the spring 7 is set so that the edge of the trench creating tool 4 is balanced in a position in which it makes contact with the surface of the solar cell substrate W to be scribed.

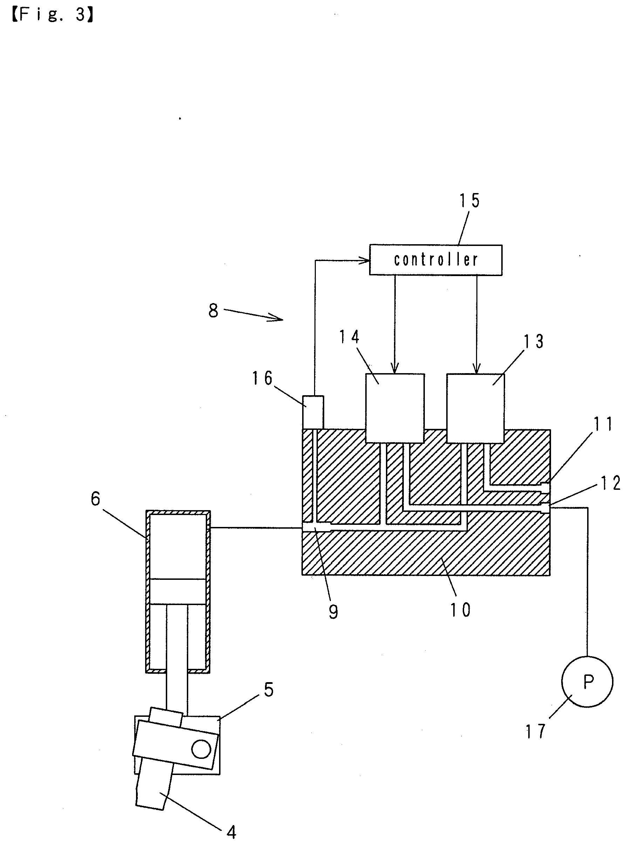

In addition, an electrical air regulator 8 is provided in order to control the pressure applied through the air cylinder 6 to a set value. As shown in Fig 3, this electrical air regulator 8 adjusts the suction and supply of air within the negative pressure port 9, and thus has a general structure for controlling the secondary pressure (pressure in the air cylinder 6). In the present embodiment, a discharge port 11 and a supply port 12 that is connected to a pump 17 are formed on one side of the main body 10 of the regulator and a negative pressure port 9 is provided on the other side, and this negative pressure port 9 is connected to the air cylinder 6.

An electromagnetic valve 13 for suction and an electromagnetic valve 14 for supply are provided in the main body 10 of the regulator, so that the electromagnetic valve 13 for suction opens to suck air from the negative pressure port 9 and closes to stop suction, and the electromagnetic valve 14 for supply opens to supply air to the negative pressure port 9 and closes to stop the air supply.

A pressure sensor 16 is provided in the negative pressure port 9 so that the pressure within the negative pressure port 9 can be detected and a signal can be sent to the controller 15. When there is a difference in pressure between the signal from the pressure sensor 16 and the reference signal that is inputted in advance, the controller 15 sends signals to the electromagnetic valve 13 for suction and the electromagnetic valve 14 for supply so as to open or close the valves.

That is to say, when the pressure within the negative pressure port 9 is lower than the set value, the electromagnetic valve 14 for supply opens, so that the air from the pump 17 is supplied to the air cylinder 6 from the negative pressure port 9. When the pressure within the negative pressure port 9 becomes of the set value, the electromagnetic valve 14 for supply closes, and the air supply is stopped. In addition, when the pressure within the negative pressure port 9 is higher than the set value, the electromagnetic valve 13 for suction opens, so that air is discharged through the discharge port 11. When the pressure within the negative pressure port 9 becomes of the set value, the electromagnetic valve 13 for suction closes, so that air discharge stops.

Thus, the pressure within the negative pressure port 9 can be kept at the set value at all times.

In the case where a trench for an electrode is created in the solar cell W having the above described structure, the blade of the trench creating tool 4 on the scribe head 1 is moved while pressed against the surface of the solar cell substrate W with a pressure of a set value by means of the air cylinder 6. In the case where the pressure in the cylinder 6 having a small diameter fluctuates during the process, the pressure is controlled to the set value by means of the electrical air regulator 8. In this case, the weight of the tool holder 5, including the trench creating tool 4, is supported by the spring 7, so that the blade is in such a position as to make contact with the surface of the solar cell substrate W with no load, and therefore the response to change in pressure is excellent, and as a result it is easy to control the whole with unprecedentedly low load of 0.1 N to 0.5 N. Furthermore, the air cylinder 6 with a small diameter is used so that the response to change in pressure is excellent and fine control with a low load is possible.

Though in the above embodiment the scribe head 1 moves in the direction X for scribing, the solar cell substrate W may move in the direction X or the direction Y instead of the scribe head 1.

Though preferred embodiments of the present invention are described, the present invention is not necessarily limited to the structures in these embodiments. For example, though the tensile force of the spring 7 is set so that the weight of the tool holder 5, including the trench creating tool 4, applies no load in such a position that the blade of the trench creating tool 4 makes contact on the surface of the solar cell substrate W in the embodiments, the position in which the weight applies no load is not particularly limited. In addition, appropriate corrections and modifications are possible as long as they fall within the scope of the invention as defined in the appended claims.

### [Industrial Applicability]

The present invention can be applied to a manufacturing method for integrated thin film solar cells using a chalcopyrite compound based semiconductor film, and a trench creating tool which can be used for this.

### [Explanation of Symbols]

- W: solar cell substrate
- 1: scribe head
- 4: trench creating tool
- 5: tool holder
- 6: air cylinder
- 7: spring
- 8: electrical air regulator

To provide a scribing apparatus with which fine adjustment with a low load is possible, thin films on the solar cell substrate can be shaved off with precision, thin films can be prevented from peeling irregularly, and straight and precise scribe lines can be created.

A scribing apparatus for thin film solar cells with which the blade of a trench creating tool 4 that is attached to the scribe head 1 is pressed against the surface of a solar cell substrate along a line along which the integrated thin film solar cell substrate W is to be scribed when the trench creating tool 4 is moved over the solar cell substrate W, so that a trench is created in the thin film formed on the surface of the solar cell substrate W, comprising: a tool holder 5 that is attached to the scribe head 1 in such a manner as to be movable upward and downward and holds the trench creating tool 4; an air cylinder 6 for pressuring the tool holder 5 against the surface of the solar cell substrate W; and a spring 7 for pressuring the tool holder 5 upward.

## Claims

1. A scribing apparatus for thin film solar cells with which the blade of a trench creating tool (4) that is attached to the scribe head (1) is pressed against the surface of a solar cell substrate (W) along a line along which the solar cell substrate (W) is to be scribed when the trench creating tool (4) is moved over the solar cell substrate (W), so that a trench is created in the thin film formed on the surface of the solar cell substrate (W), comprising: a tool holder (5) that is attached to the scribe head (1) in such a manner as to be movable upward and downward and holds the trench creating tool (4); an air cylinder (6) for pressuring the tool holder (5) against the surface of the solar cell substrate (W); and a spring (7) for pressuring the tool holder (5) upward,
**characterized in that**
said tool holder (5) comprises a rotatable attachment (5a) that is rotatable around an attachment bolt (5b), to which attachment (5a) the trench creating tool (4) is attached in such a manner that the angle at which the trench creating tool (4) is attached is adjustable.

2. The scribing apparatus for thin film solar cells according to claim 1, wherein the tensile force of the spring (7) is set so that the weight of the tool holder (5), including the trench creating tool (4), applies no load in a position where the blade of the trench creating tool (4) makes contact with the surface of the solar cell substrate (W).

## Patentansprüche

1. Ritzgerät für Dünnfilmsolarzellen, mit dem die Schneide eines Kerbenerzeugungswerkzeugs (4), das an dem Ritzkopf (1) angebracht ist, gegen die Oberfläche eines Solarzellensubstrats (W) entlang einer Linie gedrückt wird, entlang der das Solarzellensubstrat (W) zu ritzen ist, wenn das Kerbenerzeugungswerkzeug (4) über das Solarzellensubstrat (W) bewegt wird, sodass eine Kerbe in dem Dünnfilm, der auf der Oberfläche des Solarzellensubstrats (W) ausgebildet ist, erzeugt wird, mit: einer Werkzeughalterung (5), die an dem Ritzkopf (1) derart angebracht ist, dass sie nach oben und nach unten beweglich ist und das Kerbenerzeugungswerkzeug (4) hält; einem Luftzylinder (6) zum Drängen der Werkzeughalterung (5) gegen die Oberfläche des Solarzellensubstrats (W); und einer Feder (7) zum Nachobendrängen der Werkzeughalterung (5),
**dadurch gekennzeichnet, dass**
die Werkzeughalterung (5) eine drehbare Anbringungsvorrichtung (5a) aufweist, die um einen Anbringungsbolzen (5b) drehbar ist, wobei an der Anbringungsvorrichtung (5a) das Kerbenerzeugungswerkzeug (4) derart angebracht ist, dass der Winkel, in dem das Kerbenerzeugungswerkzeug (4) angebracht ist, einstellbar ist.

2. Ritzgerät für Dünnfilmsolarzellen nach Anspruch 1, wobei die Zugkraft der Feder (7) so festgelegt ist, dass das Gewicht der Werkzeughalterung (5) einschließlich des Kerbenerzeugungswerkzeugs (4) keine Last in einer Position aufbringt, in der die Schneide des Kerbenerzeugungswerkzeugs (4) mit der Oberfläche des Solarzellensubstrats (W) einen Kontakt herstellt.

## Revendications

1. Appareil de gravure pour des cellules solaires à film mince avec lequel la lame d'un outil de création de tranchée (4) qui est attaché à la tête de gravure (1) est pressée contre la surface d'un substrat de cellules solaires (W) le long d'une ligne le long de laquelle le substrat de cellules solaires (W) doit être gravé lorsque l'outil de création de tranchée (4) est déplacé sur le substrat de cellules solaires (W), de sorte qu'une tranchée soit créée dans le film mince formé sur la surface du substrat de cellules solaires (W), comprenant : un porte-outil (5) qui est attaché à la tête de gravure (1) de manière à pouvoir être déplacé vers le haut et vers le bas et qui supporte l'outil de création de tranchée (4) ; un vérin pneumatique (6) pour presser le porte-outil (5) contre la surface du substrat de cellules solaires (W) ; et un ressort (7) pour presser le porte-outil (5) vers le haut,
**caractérisé en ce que**
ledit porte-outil (5) comprend un dispositif de fixation rotatif (5a) qui est capable de tourner autour d'un boulon de fixation (5b), auquel dispositif de fixation (5a), l'outil de création de tranchée (4) est attaché d'une manière telle que l'angle selon lequel l'outil de création de tranchée (4) est attaché peut être ajusté.

2. Appareil de gravure pour des cellules solaires à film mince selon la revendication 1, dans lequel la force de traction du ressort (7) est fixée de sorte que le poids du porte-outil (5), comprenant l'outil de création de tranchée (4), n'applique aucune charge à une position où la lame de l'outil de création de tranchée (4) vient en contact avec la surface du substrat de cellules solaires (W).
